# EUROPEAN PATENT APPLICATION

(11) **EP 1 406 121 A1**
(43) Date of publication of application: **07.04.2004**
(21) Application number: 02022123.0
(22) Date of filing: 02.10.2002
(51) Int. Cl.: G03F 1/14, G03F 7/20

(54) **Reduced-stress, electrostatically chuckable reticles for use in extreme ultraviolet and soft X-ray microlithography apparatus and methods**

(71) Applicant: NIKON CORPORATION, Tokyo 100 (JP)
(72) Inventor: Ota, Kazuya, c/o Nikon Corporation, Chiyoda-ku, Tokyo 100 (JP)
(74) Representative: Meddle, Alan Leonard

(57) **Abstract**

Reflective reticles are disclosed that exhibit reduced intend stress and that are capable of being electrostatically chucked to a reticle stage, even if the reticle substrate is made from low-expansion (LE) glass, LE-ceramic, or analogous reticle substrate. If the reticle is made from LE-glass, for example, the reticle includes a conductive layer formed on the surface of the reticle nonnally contacting the reticle chuck. Another LE material that can be used is "Super Invar," which is conductive and does not require a conductive layer per se, but desirably includes a conductive "flattening layer." Internal stress in the reticle is reduced by using a LE reticle substrate and by controlling the thickness and "stress code" of the conductive and/or flattening layers.

## Description

### Field

This disclosure pertains to microlithography, which is a key technology used in the fabrication of microelectronic devices such as semiconductor integrated circuits, displays, and the like. More specifically, the disclosure pertains to pattern-defining reticles used in microlithography, especially multilayer-film reflective reticles as used in "extreme ultraviolet" ("EUV", also termed "soft X-ray" or "SXR") microlithography. Even more specifically. the disclosure pertains to methods and devices for holding such a reticle and reducing stress in the reticle.

### Background

In recent years, as semiconductor integrated circuits, displays, and other types of microelectronic devices have become progressively more miniaturized and more densely packed, the need to achieve increasingly finer resolution in microlithography has become acute. Most microlithography currently performed still is the so-called "optical microlithography" performed using deep ultraviolet light. Unfortunately, obtaining increasingly finer resolution with optical microlithography than currently achieved is limited severely by the diffraction limit of light. Consequently, substantial effort is being expended in the development of a practical "next generation" lithogaphy (NGL) technology.

One promising NGL technology is projection microlithography performed using certain X-ray wavelengths, which are substantially shorter than the wavelengths of VUV light currently used in optical microlithography. One X-ray band showing exceptional promise is the so-called "extreme ultraviolet" (EUV) band (also termed "soft X-ray" or SXR light) generally having a wavelength range of 5-20 nm. Most EUV lithography (EUVL) development has been in the wavelength range of 11 to 13 nm.

EUVL is performed using a reflective reticle (rather than a transmissive reticle as used in optical microlithography). Initially, it was proposed to fabricate an EUV reflective reticle from a silicon wafer. This approach was impractical because of the effects of reticle heating and expansion due to absorption by the reticle of incident EUV radiation. As a result of thermal expansion, the pattern defined on the reticle is dimensionally distorted sufficiently to degrade layer-overlay accuracy excessively for microlithography at the 70-nm node and below. Based on these experiences, fabrication of EUVL reticles from extra-low-expansion glassy materials has been investigated, such materials including ZERODUR® made by the Schott Corporation and ULE® glass made by Corning.

In essentially all types of projection microlithography, the reticle is held by a reticle chuck mounted to a ''reticle stage" that provides controlled movements and positioning of the reticle as required. Two principal techniques are used for holding a reticle to a reticle chuck: vacuum suction and electrostatic attraction. However, in EUV microlithography, both these techniques pose certain challenges. For example, because glass is electrically non-conductive, if a low-expansion glass is used as the reticle material, the reticle conventionally cannot be secured electrostatically to a reticle chuck. Also, EUV light is attenuated considerably in gaseous atmospheres, including He. Consequently, the optical components and stages of an EUV microlithography apparatus must be sequestered in a vacuum environment, which conventionally renders it impossible to secure the reticle by vacuum suction to a reticle chuck. In EUVL, mechanical mounting of the reticle has been tried, but with unsatisfactory results. Electrostatic mounting of the reticle is the preferred approach, if a practical manner of doing so were available.

A conventional EUVL reticle comprises a multilayer film applied to a major surface of the glassy substrate. The multilayer film renders the major surface of the substrate reflective to incident EUV light. Elements of the pattern are defined by a patterned EUV-absorbing layer on the surface of the multilayer film. Internal stresses tend to be generated and to accumulate in the reticle during formation of the multilayer film and absorption layer. These internal stresses cause distortion of the reticle. Excessive reticle distortion causes certain undesirable conditions, such as a shift of the exposure field outside the DOF (depth of focus) of the projection-optical system of the microlithography apparatus. Even if exposure-field shift remains within the DOF, reticle distortion can warp the reticle plane sufficiently to cause lateral shifting of pattern elements on the reticle. Since the projection-optical system of the EUVL system is not telecentric on the reticle side, these shifts can cause excessive overlay errors of patterns as projected onto a lithographic substrate. Also, whenever a plate-like glass substrate having a limited thickness becomes warped, distortion can occur not only in a direction perpendicular to the reticle plane (out-of-plane distortion, abbreviated OPD), but also in directions within the reticle plane (in-plane distortion, abbreviated IPD). IPD "horizontally" dislocates pattern elements from their ideal locations on the reticle, and principally causes overlay errors of patterns projected onto the substrate.

### Summary

In view of the shortcomings of the prior art as summarized above, the present invention provides, *inter alia,* EUVL reticles exhibiting reduced internal stress and an ability to be chucked electrostatically onto a reticle stage.

According to a first aspect of the invention, EUV-microlithography reticles are provided. An embodiment of such a reticle comprises an electrically non-conductive reticle substrate having first and second major surfaces. A multilayer film is formed on the first major surface and is configured for reflecting EUV light incident to a surface of the multilayer film. An EUV-absorbing layer is formed on the surface of the multilayer film, wherein the EUV-absorbing layer is patterned so as to define an exposure pattern. An electrically conductive layer is formed on the second major surface. The reticle substrate can be made of a glassy material, such as low-expansion (LE) glass having a coefficient of linear expansion of 100×10⁻⁹/K or less. Alternatively, the reticle substrate can be a LE-ceramic material, desirably also having a coefficient of linear expansion of 100×10⁻⁹/K or less.

The electrically conductive layer desirably is configured to impart a preselected type and magnitude of stress to the reticle that cancels at least a portion of an internal stress imparted to the reticle by at least the multilayer fllm. The types of stress include compressive and tensile stresses. Further desirably, the electrically conductive layer imparts a preselected type and magnitude of stress to the reticle that cancels at least a portion of an internal stress imparted to the reticle by a sum of residual stress in the multilayer film and a mean residual stress in the patterned EUV-absorbing layer.

An EUV-microlithography reticle according to another embodiment comprises a reticle substrate made of Super Invar and having first and second major surfaces. A first flattening layer is formed on the first major surface, and a multilayer film is formed on the first flattening layer. The multilayer film is configured for reflecting EUV light incident to a surface of the multilayer film. The reticle also includes an EUV-absorbing layer formed on the surface of the multilayer film, wherein the EUV-absorbing layer being patterned so as to define an exposure pattern. Desirably, the Super Invar substrate has a coefficient of linear expansion of 100×10⁻⁹/K or less.

The first flattening layer can be a layer of metal formed by electroless plating, wherein the multilayer film is formed on a polished surface of the first flattening layer. The reticle further can comprise a second flattening layer formed on the second major surface. The second flattening layer desirably is electrically conductive, e.g., a layer of metal formed by electroless plating and having a polished surface. The polished surface is suitable for electrostatically holding the reticle, by the polished surface, to an electrostatic chuck. Desirably, the second flattening layer imparts a preselected type and magnitude of stress to the reticle that cancels at least a portion of an internal stress imparted to the reticle by at least the multilayer film. Further desirably, the second flattening layer imparts a preselected type and magnitude of stress to the reticle that cancels at least a portion of an internal stress imparted to the reticle by a sum of residual stress in the multilayer film and a mean residual stress in the patterned EUV-absorbing layer.

An EUV-microlithography reticle according to yet another embodiment comprises a reticle substrate made of a low-expansion ceramic of which a coefficient of linear expansion is 100×10⁻⁹/K or less. A first flattening layer is formed on the first major surface, and a multilayer film is formed on the first flattening layer. The multilayer film is configured for reflecting EUV light incident to a surface of the multilayer film. An EUV-absorbing layer is formed on the surface of the multilayer film, the EUV-absorbing layer being patterned so as to define an exposure pattern. In this embodiment, the first flattening layer desirably is alayer of metal formed by electroless plating, wherein the multilayer film is formed on a polished surface of the first flattening layer. A second flattening layer (desirably electrically conductive) can be formed on the second major surface. More specifically, the second flattening layer desirably is a layer of metal formed by electroless plating and has a polished surface. The second flattening layer desirably imparts a preselected type and magnitude of stress to the reticle that cancels at least a portion of an internal stress imparted to the reticle by at least the multilayer film. More desirably, the second flattening layer imparts a preselected type and magnitude of stress to the reticle that cancels at least a portion of an internal stress imparted to the reticle by a sum of residual stress in the multilayer film and a mean residual stress in the patterned EUV-absorbing layer.

According to another aspect of the invention, methods are provided for fabricating an EUV-microlithography reticle. According to one embodiment of such a method, on a first major surface of a reticle substrate (having a coefficient of linear expansion of 100×10⁻⁹/K or less) a multilayer film is formed that is configured for reflecting EUV light incident to a surface of the multilayer film. An EUV-absorbing layer is formed on the surface of the multilayer film. The EUV-absorbing layer is patterned so as to define a pattern in the EUV-absorbing layer. On a second major surface of the reticle substrate, a layer is formed that imparts a preselected type and magnitude of stress to the reticle that cancels at least a portion of an internal stress imparted to the reticle by at least the multilayer film. The reticle substrate can be made of a material selected from the group consisting of LE-glasses, LE-ceramics, and Super Invar.

If the reticle substrate is made of a US-glass or a LE-ceramic, then the layer formed on the second major surface desirably is a conductive metal layer. Also, the layer formed on the second major surface also is a polished flattening layer.

If the reticle substrate is made of Super Invar, then the layer formed on the second major surface desirably is a polished flattening layer.

If the reticle substrate is made of a LE-ceramic or Super Invar, then the method further can comprise the step, before morning the first multilayer film, of forming a flattening layer on the first major surface, then forming the multilayer film on a surface of the flattening layer.

According to yet another aspect of the invention, EUV-microlithography apparatus are provided. An embodiment of such an apparatus comprises an illumination-optical system that is configured to guide a beam of EUV light to a pattern-defining EUV-reflective reticle. The apparatus also includes a projection-optical system that is situated relative to the reticle and illumination-optical system and is configured to guide the beam of EUV light from the reticle to a sensitive substrate, so as to transfer the pattern from the reticle to the sensitive substrate. The apparatus also includes a reticle stage that comprises an electrostatic reticle chuck situated and is configured to secure the reticle to the reticle stage. The reticle comprises an electrically non-conductive reticle substrate having first and second major surfaces. The reticle also includes a multilayer film that is formed on the first major surface and is configured for reflecting EUV light incident to a surface of the multilayer film. The reticle also includes an EUV-absorbing layer formed on the surface of the multilayer film, wherein the EUV-absorbing layer is patterned so as to define an exposure pattern. The reticle also includes an electrically conductive layer formed on the second major surface, wherein the electrically conductive layer is configured so as to be attracted electrostatically to the reticle chuck.

The electrostatic chuck desirably comprises a reticle-mounting surface configured to be electrically grounded. The chuck also comprises contact needles extending from the electrostatic chuck toward the electrically conductive layer. The contact needles are configured to make and maintain electrical contact with the electrically conductive layer so as to apply an electrical potential to the electrically conductive layer sufficient for attracting the reticle electrostatically to the reticle-mounting surface.

The apparatus further can comprise a drop-prevention mechanism attached to the reticle stage and configured for preventing an unintended drop of the reticle from the reticle chuck whenever the reticle is mounted electrostatically to the reticle-mounting surface of the reticle chuck.

The reticle further can have any of the features summarized above with respect to the reticle embodiments.

Another embodiment of an EUV-microlithography apparatus comprises an illumination-optical system, a projection-optical system, and reticle stage as summarized above. The reticle portion of the apparatus comprises an electrically conductive reticle substrate having first and second major surfaces and a coefficient of linear expansion is 100×10⁻⁹/K or less. The reticle also includes a multilayer film formed on the first major surface, wherein the multilayer film is configured for reflecting EUV light incident to a surface of the multilayer film. The reticle also includes an EUV-absorbing layer that is formed on the surface of the multilayer film and that is patterned so as to define an exposure pattern. The reticle further can include a polished flattening layer on the second major surface, as summarized earlier above.

The electrostatic chuck in this embodiment desirably comprises a reticle-mounting surface and contact needles as summarized above. The contact needles desirably are configured so as to make and maintain electrical contact with the polished surface so as to apply an electrical potential to the flattening layer sufficient for electrostatically attracting the reticle to the reticle-mounting surface.

The apparatus further can comprise a drop-prevention mechanism as summarized above, and the reticle further can have any of the features summarized above with respect to the reticle embodiments.

According to yet another aspect of the invention, methods are provided for transferring a pattern, defined on a reticle, to a sensitive substrate. An embodiment of such a method comprises configuring the reticle as an electrically non-conductive reticle substrate having first and second major surfaces, a multilayer film formed on the first major surface and configured for reflecting EUV light incident to a surface of the multilayer film, an EUV-absorbing layer formed on the surface of the multilayer film and patterned so as to define the pattern, and an electrically conductive layer formed on the second major surface. The reticle is placed on an electrostatic chuck of a reticle stage such that the electrically conductive layer contacts a mounting surface of the chuck. The chuck is energized so as to hold the reticle electrostatically to the chuck. A beam of EUV illumination light is guided to the reticle so as to illuminate at least a portion of the pattern with the beam, thereby producing an EUV patterned beam carrying an aerial image of the illuminated portion of the pattern. The patterned beam is guided from the reticle to a sensitive substrate using a projection-optical system so as to imprint the image, carried by the patterned beam, on the substrate.

The mounting surface of the electrostatic chuck desirably is electrically grounded, wherein the chuck desirably further comprises needle-shaped contact members that extend toward the conductive layer and apply a prescribed voltage to the conductive layer whenever the reticle is mounted on the chuck. The chuck thus secures the reticle to the reticle stage by bringing the conductive layer into contact with the mounting surface while providing the prescribed voltage via the contact members to the conductive layer.

The conductive layer of the reticle imparts a preselected type and magnitude of stress to the reticle in the manner summarized earlier above.

The reticle substrate can be LB-glass or LE-ceramic having a coefficient of linear expansion is 100×10⁻⁹/K or less. In this configuration the electrically conducive layer desirably also serves as a first flattening layer. The reticle further can comprise a second flattening layer formed on the first major surface and situated between the reticle substrate and the multilayer film.

In another embodiment of this method, the reticle is configured as an electrically conductive reticle substrate having first and second major surfaces and a coefficient of linear expansion of 100×10⁻⁹/K or less. The reticle also includes a multilayer film formed on the first major surface and that is configured for reflecting EUV light incident to a surface of the multilayer film. The reticle also includes an EUV-absorbing layer formed on the surface of the multilayer film and patterned so as to define the pattern, and a first flattening layer formed on the second major surface. The reticle is placed on an electrostatic chuck of a reticle stage such that the first flattening layer contacts a mounting surface of the chuck. The chuck is electrostatically energized to hold the reticle to the chuck. A beam of EUV illumination light is guided to the reticle so as to illuminate at least a portion of the pattern with the beam, thereby producing an EUV patterned beam carrying an aerial image of the illuminated portion of the pattern. The patterned beam is guided from the reticle to a sensitive substrate using a projection-optical system so as to imprint the image, carried by the patterned beam, on the substrate.

The reticle substrate can be made of Super Invar, in which event the reticle desirably further comprises a second flattening layer formed on the first major surface and situated between the first major surface and the multilayer film. The first and second flattening layers desirably are respective conductive metal layers. In this instance, the mounting surface of the electrostatic chuck is electrically grounded, and the chuck further comprises needle-shaped contact members that extend toward the first flattening layer and apply a prescribed voltage to the first flattening layer whenever the reticle is mounted on the chuck. The chuck secures the reticle to the reticle stage by bringing the first flattening layer into contact with the mounting surface while providing the prescribed voltage via the contact members to the first flattening layer.

The first flattening layer desirably imparts a preselected type and magnitude of stress to the reticle, in the manner summarized earlier above.

The foregoing and additional features and advantages of the invention will be more readily apparent from the following detailed description, which proceeds with reference to the accompanying drawings.

### Brief Description of the Drawings

FIG. 1 is an elevational section of a portion of a reflective reticle according to a first representative embodiment.
FIG. 2 is an elevational section of a portion of a reflective reticle according to a second representative embodiment.
FIG. 3 is an elevational section of a portion of a reflective reticle according to a third representative embodiment.
FIG. 4 is a schematic elevational diagram of certain components and imaging relationships in an EUV lithography (EUVL) apparatus, according to a fourth representative embodiment configured to utilize a reflective reticle as described, for example, many of the first, second, and third representative embodiments.
FIG. 5 is a schematic elevational section of a reticle stage, reticle chuck, and reticle in the apparatus shown in FIG. 4.

### Detailed Description

The invention is described below in the context of multiple representative embodiments that are not intended to be limiting in any way.

### First Representative Embodiment

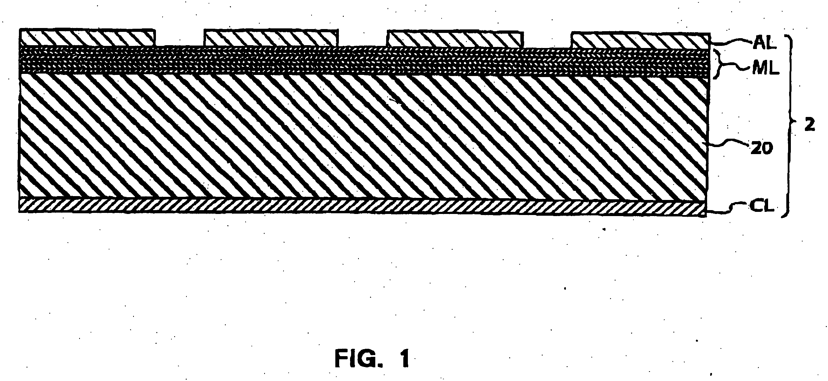

A reflective reticle 2 according to this embodiment is shown in FIG. 1, showing an elevational section of a portion of the reticle. The reticle 2 is especially suitable for use in an EUVL apparatus. The reticle 2 includes a low-expansion (LE) glass substrate 20 having a first major surface ("upper" surface in the figure) on which a multilayer film ML is formed. The multilayer film ML provides the glass substrate with high reflectivity for the particular wavelength of incident EUV light. An EUV-absorbing "patterning" layer (*e.g*., an EUV-absorbing layer AL) is formed on the surface of the multilayer film ML. The EUV-absorbing layer AL is patterned to define the elements of the pattern defined by the reticle 2, wherein the elements are defined according to the local presence or absence of the absorption layer AL. An electrically conductive layer CL is formed on the second major surface ("lower" surface in the figure) of the substrate 20. The surface of the conductive layer CL is the "mounting surface" of the reticle 2, by which is meant that the reticle 2 is mounted by this surface to the surface of a reticle chuck mounted to the reticle stage.

As a result of the presence of the conductive layer CL, it now is possible to chuck the reticle 2 electrostatically even though the reticle substrate 20 is made of electrically insulative LE-glass. The multilayer film ML, absorption layer AL, and conductive layer CL are formed by respective sputtering steps. Various materials can be used for forming the conductive layer CL, including any of various conductor and semiconductor metals in general. Examples include; but are not limited to, Cr, Ni, Ta, and alloys of these metals. The multilayer film ML is made of multiple alternating layers of at least two materials selected to provide maximal reflectivity for the particular EUV wavelength to be used for microlithography. For example, for a wavelength in the vicinity of 13 nm to 14 nm, the multilayer film ML desirably comprises 40 to 50 layer-pairs of Mo (molybdenum) and Si (silicon) alternatingly laminated at a period length (layer-pair thickness) of approximately half the wavelength of the intended EUV light A multilayer film ML having such a configuration can provide approximately 70% reflectivity to normally incident EUV light.

The multilayer film ML normally is formed by sputtering. Under certain conditions, sputtering can be performed at "room temperature," which tends to generate less stress in the multilayer film ML. Nevertheless, room-tenterature sputtering can generate several hundred MPa (megapascals) of compressive stress in the multilayer film ML. To reduce deformation of the LE-glass substrate 20 caused by such stress, the conductive layer CL formed on the second major surface of the LE-glass substrate 20 is made under carefully controlled conditions so as to impart a Type and magnitude of stress to the reticle that offsets (*i.e.,* at least partially cancels) the compressive stress generated in the multilayer film ML.

Specifically, the conductive layer CL is formed so as to have the same type of internal stress as present in the multilayer film ML. Here, "internal stress" can be a compressive stress or a tensile stress, and is expressed as force per unit thickness of the film. For example, the conductive layer CL can be formed so as to have several hundred MPa of stress, equal to the magnitude of stress in the Mo/Si multilayer film ML, wherein the thickness of the conductive layer CL is equal to the thickness of the Mo/Si multilayer film ML. By generating an internal stress on the second major surface of the LE-glass substrate equal to the internal stress on the first major surface of the LE-glass substrate, the net stress on (and thus deformation of) the LE-glass substrate 20 is reduced substantially.

By way of another example, if on the second major surface a conductive layer CL is formed having twice the internal stress of the Mo/Si multilayer film ML on the first major surface, then the thickness of the conductive layer CL can be made half the thickness of the multilayer film ML. Again, the net stress largely is canceled, which substantially reduces deformation of the LE-glass substrate 20 and hence of the reticle.

Forming pattern elements in the absorption layer AL partially releases internal stress otherwise present in the layer. However, the residual stress in this layer, after forming the pattern elements, can produce an undesirable distribution of stress in the LE-glass substrate 20. Hence, the internal stress in the absorption layer AL desirably is made as close to zero as possible. Even if the internal stress of this layer is not brought to zero, the average residual internal stress after patterning the layer can be calculated in advance. Based on the results of the calculations, the type of stress to be generated by the conductive layer CL (and the thickness of the conductive layer CL) are selected carefully so that a conductive layer CL can be formed having an internal stress "tailored" to cancel at least some of the mean residual stress in the absorption layer AL and in the multilayer film ML.

More specifically, the combined stress of the absorption layer AL and the multi-layer film ML formed on the first major surface of the LE-glass substrate 20 is canceled by the internal stress deliberately generated in the conductive layer CL. To such end, the type (*i.e.,* compressive or tensile stress) and magnitude of stress produced in the conductive layer CL are selected by appropriately controlling the thickness and material of the conductive layer CL formed on the second major surface of the LE-glass substrate.

Exemplary methods for producing a selected type and magnitude of stress in the conductive layer CL include: (a) selection of the material of the conductive layer CL, and (b) modifications of steps and of film-formation conditions in the method used to form the conductive layer CL. Different layer-forming materials generate respectively different types and magnitudes of stress during formation of the conductive layer from such materials. Also, with a given layer-forming material, the magnitude of internal stress actually generated in the conductive layer CL varies according to the method used for forming the layer and according to specific conditions under which the layer is formed. Hence, by appropriately selecting the material and/or adjusting the film-formation method and film-formation conditions, the internal stress in the conductive layer CL can be tailored appropriately.

Examples of suitable film-formation methods are sputtering and electron-beam deposition. Note that, in order to satisfy optical-performance criteria with respect to EUV light, the respective thicknesses of the multilayer film ML and of the absorption layer AL cannot be varied significantly from respective design-mandated values. But, the range in which the thickness of the conductive layer CL may be varied is relatively large.

The LE-glass substrate desirably has an extremely low coefficient of linear expansion, for example, 10×10⁻⁹/K or less. With such a reticle substrate, if the temperature of the reticle 2 is increased by 1 K, then the resulting expansion of a 100-nm field of the reticle is 1 nm end-to-end, which translates (at a 1/4 demagnification ratio) to 0.25 nm on the substrate. These figures do not adversely affect overlay error significantly in any of the 70-nm, 50-nm, or 30-nm nodes. For example, the overlay accuracy obtained at the 30-nm node is 10 nm at 1/3 linewidth (*i.e.*, (30nm)/3 = 10 nm). The portion of 10 nm represented by the 0.25-nm expansion manifest on the substrate is sufficiently small to be ignored.

By way of another example, if the coefficient of linear expansion of the LE-glass substrate 20 is 10×10⁻⁹/K or less, then expansion of a 100-nm field of the reticle accompanying a 10 °C temperature increase of the reticle is 10 nm end-to-end. At 1/4 demagnification, this 10-nm expansion translates to an expansion of only 2.5 nm on the substrate. This is equivalent to a tolerance of ±1.25 nm on the substrate, which usually can be accommodated even at the 30-nm node. If it is known that the temperature increase of the reticle will be limited to 1 °C, then the resulting expansion of the reticle likely will be tolerable even if the coefficient of linear expansion is 100×10⁻⁹/K.

The magnitude of temperature increase experienced by an irradiated reticle depends upon the energy of the EUV light incident on the reticle, the efficiency with which the incident energy is absorbed by the reticle, and the efficiency with which the reticle is cooled while mounted on the reticle stage. Since the reticle is situated in a vacuum during use, exemplary methods for cooling the reticle include cooling from the second major surface by beat conduction and situating a cooling body at a location opposite the patterned surface (first major surface) to absorb irradiated heat from the reticle.

The reflective reticle 2 can include a "buffer layer" for protecting the reticle pattern during pattern-correction procedures, as well as an etch-stop layer (used during formation of the pattern in the absorption layer AL). These two layers, if present, typically are situated between the multilayer film ML and the absorption layer AL. During patterning of the absorption layer AL, portions of the absorption layer AL are removed. Corresponding portions of the buffer layer and etch-stop layer normally are removed also. However, respective portions of the buffer layer and etch-stop layer remain beneath remaining portions of the absorption layer AL. Whenever these residual portions of the buffer layer and etch-stop layer are present, their respective internal stresses desirably are considered when calculating the internal stress of the multilayer film ML.

### Second Representative Embodiment

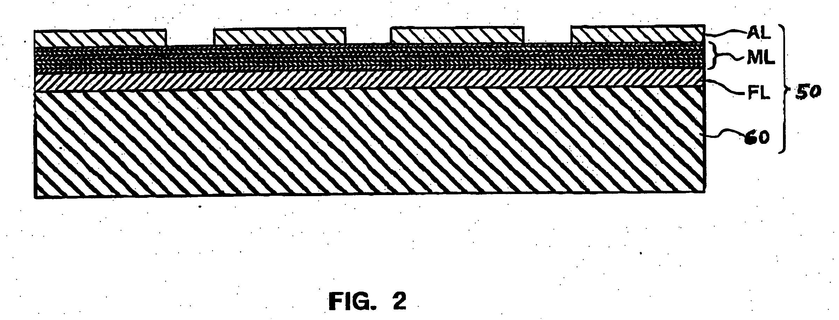

A reflective reticle 50 according to this embodiment is shown in FIG. 2, showing an elevational section of a portion of the reticle. The reticle 50 is especially suitable for use in an EUVL apparatus. The reticle 50 includes a "Super Invar" substrate 60 serving as the reticle substrate. Super Invar is an alloy of 31-32% w/w nickel (Ni) and 4-5 % w/w cobalt (Co), and balance iron (Fe). This alloy has a coefficient of linear expansion that is even less than the alloy called "Invar" (34-36 % w/w Ni, balance Fe). Super Invar has poor machinability, and countless microscopic bumps remain on the surface thereof after grinding and polishing. On the surface of a reticle substrate made from Super Invar, the remaining bumps have dimensions approximately equal to the wavelength of EUV light to be incident on the reticle. These bumps would tend to scatter the incident light and thus degrade the EUV-reflectivity of a reflective multilayer film formed on the surface. To prevent this scattering, a flattening layer FL is formed on the first major surface of the Super Invar substrate 60 on which the multilayer film ML will be formed. A flattening layer also is termed a "planarizing layer" in the art, but the term "flattening layer" is retained herein.

The flattening layer FL desirably is a metal layer, *e.g.*, a layer of Ni formed by electroless plating. Even though the portion of the flattening layer FL actually contacting the first major surface of the Super Invar substrate reproduces the bumps on the Super Invar surface, the opposite surface of the flattening layer FL can be polished very finely. *E.g.,* a Ni flattening layer can be polished to have a planar surface exhibiting the same degree of flatness as, *e.g.,* polished glass.

Formed on the surface ("upper" surface in the figure) of the flattening layer FL is a multilayer film ML that provides high reflectivity to incident EUV light. Formed on the surface ("upper" surface in the figure) of the multilayer film ML is an absorption layer (EUV-absorbing layer) AL. The absorption layer At is patterned so as to define, by voids and surrounding non-voids in the absorption layer AL, the pattern to be defined on the reticle.

As a specific example of the multilayer film ML for reflection of incident EUV light, if the EUV wavelength is in the vicinity of 13 to 14 nm, the multilayer film ML desirably comprises 40 to 50 layer-pairs of Mo and Si alternatingly laminated at a period length of approximately half the wavelength. A multilayer film ML having such a configuration can provide approximately 70% reflectivity to normally incident EUV light.

The multilayer film ML normally is formed by sputtering, which can be performed at "room" temperature. Sputtering performed even under such mild conditions can generate several hundred MPa of compressive stress in the multilayer film ML. But, because the Super Invar substrate 60 has greater rigidity than conventional glass, the consequential deformation thereof resulting from stress in the multilayer film ML and the absorption layer AL is small.

Specifically, the coefficient of linear expansion of Super Invar is extremely small, 10×10⁻⁹/K or less. With such a reticle substrate, if the temperature of the reticle 50 is increased by 1 K, then the resulting expansion of a 100-mm field of the reticle is 1 nm end-to-end, which translates (at a 1/4 demagnification ratio) to a positional shift on the substrate of (1 nm)(1/4) = 0.25 nm. This error does not produce a significant overlay error in the 70-mn, 50-nm, or 30-nm nodes of exposure. For example, the overlay accuracy obtained at the 30-nm node is 10 nm at 1/3 linewidth. The portion of 10 nm represented by an error of 0.25 nm on the substrate is sufficiently small to be ignored.

By way of another example, if the coefficient of linear expansion of the Super Invar substrate 60 is 10 × 10⁻⁹/K or less, then expansion of a 100-nm field of the reticle is 10 nm end-to-end accompanying a 10 °C temperature increase of the reticle. A 1/4 demagnification, this 10-nm expansion translates to an expansion of only (10 nm)(1/4) = 2.5 nm on the substrate. This is equivalent to a tolerance of ±1.25 nm on the substrate, which usually can be accommodated even at the 30-nm node. If it is known that the temperature increase of the reticle will be limited to 1 °C, then the resulting expansion of the reticle likely will be tolerable even if the coefficient of linear expansion is 100×10⁻⁹/K.

As noted above, the magnitude of temperature increase experienced by an irradiated reticle depends upon the energy of the EUV light incident on the reticle, the efficiency with which the incident energy is absorbed by the reticle, and the efficiency with which the reticle is cooled while mounted on the reticle stage. Since the reticle is situated in a vacuum during use, exemplary methods for cooling the reticle include cooling from the second major surface by heat conduction and situating a cooling body at a location opposite the patterned surface (first major surface) to absorb irradiated heat from the reticle.

The reticle 50 can include a "buffer layer" for protecting the reticle pattern during pattern-correction procedures, as well as an etch-stop layer (used during formation of the pattern in the absorption layer AL). These two layers, if present, typically are situated between the multilayer film ML and the absorption layer AL. During patterning of the absorption layer AL, portions of the absorption layer AL are removed by etching. Corresponding portions of the buffer layer and etch-stop layer normally are removed also. However, respective portions of the buffer layer and etch-stop layer remain beneath remaining portions of the absorption layer AL. Whenever these residual portions of the buffer layer and etch-stop layer are present, their respective internal stresses are considered when calculating the internal stress of the multilayer film ML.

An advantage of the Super Invar substrate 50 is that it is electrically conductive, which allows the reticle to be mounted electrostatically to a reticle chuck without having to provide the reticle with a separate conductive layer as in the first representative embodiment.

### Third Representative Embodiment

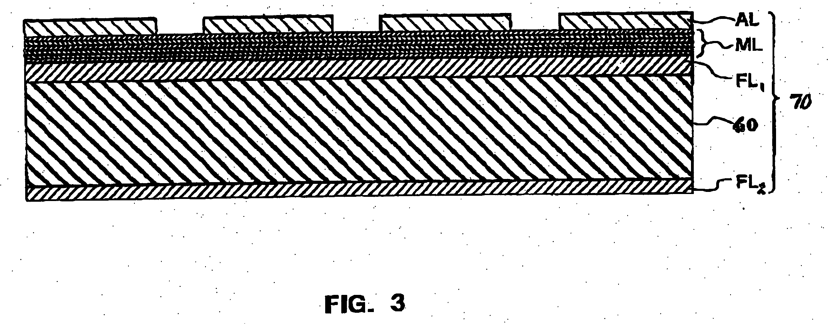

A reflective reticle 70 according to this embodiment is shown in FIG. 3, showing an elevational section of a portion of the reticle. The reticle 70 is especially suitable for use in an EUVL apparatus. In this embodiment, components that are similar to corresponding components in the second representative embodiment have the same respective reference designators.

As noted above in the second representative embodiment, since the Super Invar substrate 60 has electrical conductivity, it can be held by electrostatic attraction to a reticle chuck. The electrostatic force between the surface of the chuck and the contacting surface of the Super Invar substrate 60 varies according to the roughness of the contacting surface. If the contacting surface is excessively rough, then the reticle cannot be held to the chuck with an adequate holding force. In EUV microlithography apparatus, the reticle and the wafer are scanned simultaneously during exposure. Hence, the reticle must be held with sufficient force so as not to move relative to the chuck even under the high acceleration and deceleration forces to which the reticle is subjected during such scanning motions. Hence, in this embodiment, a second flattening layer FL₂ is formed on the surface of the Super Invar substrate 60 opposite the surface on which the first flattening layer FL₁ (described in the second representative embodiment) is applied. The second flattening layer FL₂ is polished in the same manner as the first flattening layer FL₁ so as to obtain an extremely smooth planar surface.

So as to be attracted electrostatically to the reticle chuck, the second flattening layer FL₂ must be electrically conductive. Hence, the second flattening layer FL₂ desirably is a layer of a metal, *e.g.,* Ni formed by electroless plating. Even though the portion of the second flattening layer FL₂ actually in contact with the Super Invar substrate reproduces the bumps on the Super Invar surface, the opposite surface of the second flattening layer FL₂ can be polished very finely *(i.e.,* to very low surface roughness). *E.g.,* a Ni flattening layer can be polished to have a planar surface exhibiting the same degree of flatness as, *e.g.,* polished glass. If the first and second flattening layers FL₁, FL₂, respectively, have the same thickness, then net stress of the layers can be canceled effectively, thereby reducing deformation of the reticle substrate 60. If the respective stresses in the multilayer film ML and absorption layer AL also are taken into account, the respective thicknesses of the first and second flattening layers FL₁, FL₂, respectively, can be varied as required to yield the desired low net stress in the reticle. For example, to reduce deformation of the Super Invar substrate 60, the second flattening layer FL₂ can be made to have a type and magnitude of stress serving to cancel compressive stresses in the multilayer film ML.

In other words, the second flattening layer FL₂ can be fabricated to have a compressive stress equal to the compressive stress in the multilayer film ML. As noted above, total internal stress includes components of compressive stress and tensile stress. Internal stress is expressed as force per unit thickness of the film. For example, if a second flattening layer FL₂ having a stress of several hundred MPa (similar to the stress in the Mo/Si multilayer film ML) is formed on the second major surface of the Super Invar substrate 60, then the thickness of the second flattening layer FL₂ can be made equal to the thickness of the Mo/Si multilayer film ML. Thus, the respective internal stresses of the first and second major surfaces of the Super Invar substrate 60 are balanced, which limits deformation of the Super Invar substrate 60. As another example, if a second flattening layer FL₂ having twice the internal stress of the Mo/Si multilayer film ML is formed on the second major surface of the Super Invar substrate 60, then the thickness of the second flattening layer FL₂ can be made half the thickness of the multilayer film for limiting deformation of the Super Invar substrate 60.

Whenever the absorption layer AL is patterned, internal stress in that layer is partially released. However, it is possible that a distribution of stress will be established in the Super Invar substrate 60 from residual stress in the remaining regions of me absorption layer AL. Hence, the internal stress of the absorption layer AL desirably is made as close to zero as possible. If this criterion cannot be met, then the mean residual internal stress in the absorption layer AL after patterning can be calculated in advance. Based on such data, the thickness of the second flattening layer FL₂ is established so as to produce a type and magnitude of stress serving to cancel the sum of stresses from the absorption layer AL and the multilayer film ML.

Specifically, to cancel the combined stress from the absorption layer AL and multilayer film ML by appropriate manipulation of the second flattening layer FL₂, the type and magnitude of required offsetting internal stress are determined, and the thickness of the second flattening layer FL₂ established accordingly. For example, the required type and magnitude of stress are achieved by appropriate selection of the material, the method, and the process conditions under which the second flattening layer FL₂ is formed. For example, the type and magnitude of internal stress vary according to the material of which the second flattening layer FL₂ is formed. Hence, the desired type and magnitude of stress can be realized by selecting the material of which the second flattening layer FL₂ is made.

In the second and third representative embodiments. Super Invar is used as the material of the reticle substrate 60. Since the surface roughness of Super Invar has substantial surface roughness, forming a multilayer film ML directly on a surface of Super Invar does not yield a desired high reflectivity. But, by forming a polished flattening layer (first flattening layer FL₁) on the Super Invar substrate before applying the multilayer film ML to the surface of the flattening layer, a desired reflectivity is obtained after completing formation of the multilayer film ML. Since Super Invar has a coefficient of linear expansion that is less than that of LE-glass, a reticle made using a Super Invar substrate exhibits even less thermal expansion (when irradiated with EUV light) than a reticle made using a LE-glass substrate.

Super Invar is two to three times more rigid than glass. Thus, a reticle made using a Super Invar reticle substrate exhibits very low deformation even when residual stress is present. The Young's modulus (an index of rigidity) of glass is approximately 80 GPa and approximately 200 GPa for Super Invar. Thus, using Super Invar, it is possible more effectively to prevent the exposure area on the reticle from shifting to outside the DOF (depth of focus) of the projection-optical system. It also is possible, using Super Invar, to reduce shifting of pattern elements as transferred to the lithographic substrate, to reduce overlay error, to reduce OPD (out-of-plane distortion),.and to reduce IPD (in-plane distortion). Also, since Super Invar is electrically conductive, a reticle according to this embodiment, can be held electrostatically on an electrostatic reticle chuck without the need for a conductive layer.

As an alternative to using Super Invar, the reticle substrate 60 can be made of a low-expansion (LE) ceramic, which exhibits a coefficient of linear expansion of 20×10⁻⁹/K or less. The rigidity of LE-ceramic is approximately 1.5 times (Young's modulus = 120 GPa) that of LE-glass, but not quite as high as Super Invar (see above). Thus, LE-ceramics allow satisfactory reduction of stress and deformation of the reticle substrate caused by stress generated in the thin films formed on the reticle substrate. The rigidity per unit mass of LE-ceramic, is approximately 1.5 times higher than for LE-glass and approximately 3 times higher than for Super Invar. Hence, LE-ceramic is light and strong, which is useful for preventing reticle shifts relative to the reticle stage during accelerations and decelerations incurred during scanning exposure, and for overall reduction of reticle mass. But, like Super Invar, LE-ceramic cannot be polished to the same smoothness as glass. Hence, a polished flattening or smoothing layer must be interposed between the multilayer film and the surface of the LE-ceramic substrate.

### Fourth Representative Embodiment

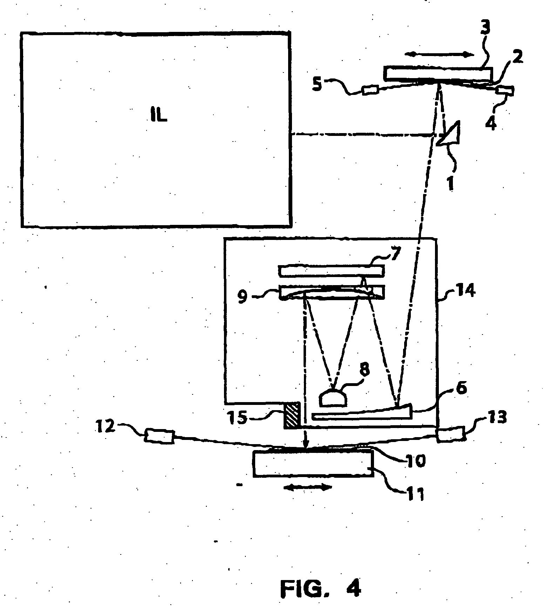

FIG. 4 is a block diagram showing the general configuration of an EUVL apparatus utilizing a reflective reticle such as any of the representative embodiments described above. The apparatus shown in FIG. 4 comprises an illumination-optical system IL that includes an EUV light source (not shown but well-understood In the art). The EUV light source produces a beam of EUV light generally having a wavelength in the range of 5 to 20 nm, more typically in the range of 11 to 13 nm. The EUV beam is emitted from the illumination-optical system IL to a reflecting mirror 1 that deflects the beam to the reticle 2. The reticle 2 is held on a retire stage 3 via a reticle chuck (not shown). The reticle stage 3 has a movement range of 100 mm or more in the scanning direction (Y direction, see arrow). The reticle stage 3 also is capable of undergoing relatively small motions ("micro-strokes") in the X direction, perpendicular to the scanning direction, within the reticle plane, and in the optical-axis direction (Z direction). The position of the reticle stage 3 in the X and Y directions is monitored at extremely high accuracy by respective laser interferometers (not shown but well understood in the art). The position of the reticle stage 3 in the Z direction it is monitored by a reticle-focus sensor comprising a light-transmission system 4 and a light-receiving system 5.

The EUV light beam (from the illumination-optical system IL) reflected from the reticle 2 includes an aerial image of the portion of the pattern, defined on the reticle, illuminated by the beam. As described above, the reticle 2 includes a reticle substrate, a multilayer film (e.g., Mo/Si or Mo/Be) reflective to incident EUV light, and a patterned absorption layer (e.g., Ni or Al) on the multilayer film.

EUV light from the reticle 2 enters a lens column 14 housing the projection-optical system. The projection-optical system comprises a first multilayer-film mirror 6, a second multilayer-film mirror 7, a third multilayer-film mirror 8, and a fourth multilayer-film mirror 9 that sequentially reflect the EUV light from the reticle and carrying the aerial image. From the fourth multilayer-film mirror 9, the EUV beam is perpendicularly incident on the lithographic substrate 10. The projection-optical system in this embodiment has a demagnification ratio of 1/4 or 1/5, for example. In, the figure, the projection-optical system is shown as having four mirrors, but it will be understood that the projection-optical system alternatively can include six to eight mirrors, which effectively would increase the numerical aperture (NA) of the system. An off-axis microscope is arranged in the vicinity of the lens column 14 for performing alignments of the substrate and reticle with each other.

For exposure the substrate 10 is mounted on a substrate stage 11. The substrate stage 11 is movable freely within a plane (X-Y plane) that is perpendicular to the optical axis of the projection-optical system. The usual range of such motions is 300-400 nm. The substrate stage 11 also is configured to exhibit "micro-stroke" movements in the Z direction for raising and lowering the substrate by small amounts as required. The positions of the substrate stage 11 in the X and Y directions are determined by respective interferometers (not shown). The position of the substrate stage 11 in the Z direction is monitored by a substrate-focus sensor comprising an autofocus light-transmission system 12 and an autofocus light-receiving system 13. During lithographic exposure, the reticle stage 3 and substrate stage 11 simultaneously scan the reticle and substrate, respectively, at respective velocities according to the demagnification ratio of the projection-optical system, e.g., at velocity ratios of 4:1 or 5:1 corresponding to respective demagnification ratios of 1/4 and 1/5.

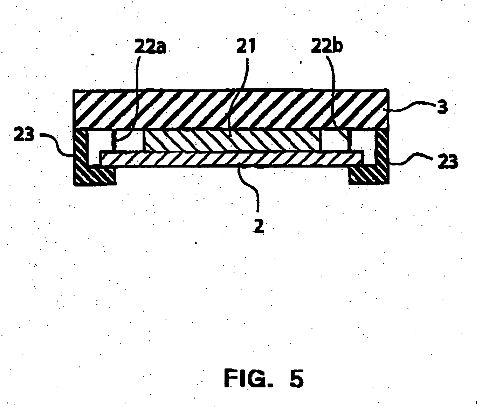

The reticle 2 typically is mounted to the reticle stage 3 by a reticle chuck 21. As described earlier above, the reticle chuck 21 desirably holds the reticle 2 electrostatically. Chucking is performed by a method having multiple steps, described below in the context of using a reticle according to, e.g., the third representative embodiment. First, as the flattening layer FL₂ of the "rear" surface of the reticle 2 is brought into contact with the reticle chuck 21, the distal ends of needles 22a, 22b are brought into contact with the flattening layer FL₂. A prescribed voltage is applied to the needles 22a, 22b (to charge the reticle electrostatically) while a ground electrical potential is being applied to the reticle chuck 21. The resulting electrostatic charge formed on the surface of the reticle chuck electrostatically attracts the reticle 2 to the surface of the chuck 21 and hence to The reticle stage 3. As surmised from FIGS. 4 and 5, the reticle 2 when mounted to the reticle chuck 21 (and reticle stage 3) is oriented face-downward.

The needles 22a, 22b are arranged outside the perimeter of the chuck 21 and extend from the downward-facing surface of the reticle stage 3. The distal ends of the needles 22a, 22b are attached to the reticle stage 3 via respective springs (not shown). During the process of chucking the reticle 2 to the reticle chuck 21, first the respective distal ends of the needles 22a, 22b are brought into contact with the electrically conductive surface of the reticle (e.g., with the conductive layer CL or flattening layer FL₂) as the reticle is brought into contact with the chuck 21. Then, a prescribed voltage is applied to the needles 22a, 22b as a ground potential is applied to the reticle chuck 21. Due to the spring-loading of each needle 22a, 22b, the distal ends of the needles remain in electrical contact with the conductive surface of the reticle 2.

The reticle stage 3 desirably also comprises drop-prevention members 23 that are situated outboard of the needles and extend downward from the surface of the reticle stage 3- The drop-prevention members 23 have respective distal ends that extend toward each other sufficiently to hold the reticle and prevent dropping of the reticle 2 in the event the reticle should become detached inadvertently from the reticle chuck 21. For example, the drop-prevention members 23 can have L-shaped profiles as shown.

In any event, as described above, the reticle is attached to the reticle chuck (and hence to the reticle stage) electrostatically due to the presence of an electrically conductive surface on the reticle. The reticle surface is electrically conductive even if the reticle substrate is not (*e.g.*, made of LE-glass or LE-ceramic).

In addition, by forming the conductive film CL or flattening layer FL₂, as described above, so as to produce a "tailored" type and magnitude of internal stress in the respective layer sufficient to cancel internal stress in the multilayer film ML, reticle distortion is reduced. Thus, it is possible to prevent the image, as exposed on the lithographic substrate, from being outside the DOF of the projection-optical system. It also is now possible to reduce shifts, relative to design-mandated locations, of pattern elements as projected onto the substate, thereby reducing the incidence of significant overlay errors. It also is now possible to reduce the incidence of significant OP distortion and significant IP distortions of projected patterns, thereby also reducing overlay errors.

Whereas the invention has been described in connection with multiple representative embodiments, the invention is not limited to those embodiments. On the contrary, the invention is intended to encompass all modifications, alternatives, and equivalents as may be included within the spirit and scope of the invention, as defined by the appended claims.

In the present specification "comprises" means "includes or consists of" and "comprising" means "including or consisting of".

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

## Claims

1. An EUV-microlithography reticle, comprising:
an electrically non-conductive reticle substrate having first and second major surfaces;
a multilayer film formed on the first major surface and configured for reflecting EUV light incident to a surface of the multilayer film;
an EUV-absorbing layer formed on the surface of the multilayer film, the EUV-absorbing layer being patterned so as to define an exposure pattern; and
an electrically conductive layer formed on the second major surface.

2. A reticle according to Claim 1, wherein the reticle substrate is made of a glassy material.

3. A reticle according to Claim 2, wherein the glassy material is a low-expansion glass of which a coefficient of linear expansion is 100x10⁻⁹/K or less.

4. A reticle according to Claim 1, wherein the reticle substrate is a low-expansion ceramic material.

5. A reticle according to any preceding claim, wherein the electrically conductive layer imparts a preselected type and magnitude of stress to the reticle that cancels at least a portion of an internal stress imparted to the reticle by at least the multilayer film.

6. A reticle according to Claim 5, wherein the type of stress is compressive or tensile stress.

7. A reticle according to Claim 5 or 6, wherein the internal stress is imparted to the reticle by a sum of residual stress in the multilayer film and a mean residual stress in the patterned EUV-absorbing layer.

8. An EUV-microlithography reticle, comprising:
a reticle substrate made of a low-expansion ceramic of which a coefficient of linear expansion is 100x10⁻⁹/K or less, the reticle substrate having first and second major surfaces;
a first flattening layer formed on the first major surface;
a multilayer film formed on the first flattening layer and configured for reflecting EUV light incident to a surface of the multilayer film; and
an EUV-absorbing layer formed on the surface of the multilayer film, the EUV-absorbing layer being patterned so as to define an exposure pattern.

9. An EUV-microlithography reticle according to Claim 8, wherein the reticle substrate is made of Super Invar.

10. A reticle according to Claim 8 or 9, wherein:
the first flattening layer is a layer of metal formed by electroless plating; and
the multilayer film is formed on a polished surface of the first flattening layer.

11. A reticle according to any one of Claims 8 to 10, further comprising a second flattening layer formed on the second major surface, the second flattening layer being electrically conductive.

12. A reticle according to Claim 11, wherein:
the second flattening layer is a layer of metal formed by electroless plating; and
the second flattening layer has a polished surface.

13. A reticle according to Claim 12, wherein the polished surface is suitable for electrostatically holding the reticle, by the polished surface, to an electrostatic chuck.

14. A reticle according to any one of Claims 11 to 13, wherein the second flattening layer imparts a preselected type and magnitude of stress to the reticle that cancels at least a portion of an internal stress imparted to the reticle by at least the multilayer film.

15. A reticle according to Claim 14, wherein the type of stress is compressive or tensile.

16. A reticle according to Claim 14 or 15, wherein the internal stress is imparted to the reticle by a sum of residual stress in the multilayer film and a mean residual stress in the patterned EUV-absorbing layer.

17. A method for fabricating an EUV-microlithography reticle, comprising:
on a reticle substrate of which a coefficient of linear expansion is 100x10⁻⁹/K or less, forming on a first major surface thereof a multilayer film configured for reflecting EUV light incident to a surface of the multilayer film;
on the surface of the multilayer film, forming an EUV-absorbing layer;
patterning the EUV-absorbing layer so as to define a pattern in the EUV-absorbing layer; and
on a second major surface of the reticle substrate, forming a layer that imparts a preselected type and magnitude of stress to the reticle that cancels at least a portion of an internal stress imparted to the reticle by at least the multilayer film.

18. A method according to Claim 17, wherein the reticle substrate is made of a LE-glass, a LE-ceramic or Super Invar.

19. A method according to Claim 17 or 18, wherein:
the reticle substrate is made of a LE-glass or a LE-ceramic; and
the layer formed on the second major surface is a conductive metal layer.

20. A method according to Claim 19, wherein the layer formed on the second major surface also is a polished flattening layer.

21. A method according to Claim 17, wherein:
the reticle substrate is made of Super Invar; and
the layer formed on the second major surface is a polished flattening layer.

22. A method according to Claim 17, wherein:
the reticle substrate is made of a LE-ceramic or Super Invar; and
the method further comprises the step, before forming the first multilayer film, of forming a flattening layer on the first major surface, then forming the multilayer film on a surface of the flattening layer.

23. An EUV-microlithography apparatus, comprising:
an illumination-optical system configured to guide a beam of EUV light to a pattern-defining EUV-reflective reticle;
a projection-optical system situated relative to the reticle and illumination-optical system, and configured to guide the beam of EUV light from the reticle to a sensitive substrate, so as to transfer the pattern from the reticle to the sensitive substrate; and
a reticle stage comprising an electrostatic reticle chuck situated and configured to secure the reticle to the reticle stage, wherein the reticle comprises an electrically non-conductive reticle substrate having first and second major surfaces, a multilayer film formed on the first major surface and configured for reflecting EUV light incident to a surface of the multilayer film, an EUV-absorbing layer formed on the surface of the multilayer film and patterned so as to define an exposure pattern, and an electrically conductive layer formed on the second major surface, the electrically conductive layer being configured so as to be attracted electrostatically to the reticle chuck.

24. An apparatus according to Claim 23, wherein the electrostatic chuck comprises:
a reticle-mounting surface configured to be grounded electrically; and
contact needles extending from the electrostatic chuck toward the electrically conductive layer and configured so as to make and maintain electrical contact with the electrically conductive layer so as to apply an electrical potential to the electrically conductive layer sufficient to attract the reticle electrostatically to the reticle-mounting surface.

25. An apparatus according to Claim 24, further comprising a drop-prevention mechanism attracted to the reticle stage and configured for preventing an unintended drop of the reticle from the reticle chuck whenever the reticle is mounted electrostatically to the reticle-mounting surface of the reticle chuck.

26. An apparatus according to Claim 25, wherein the electrically conductive layer imparts a preselected type and magnitude of stress to the reticle that cancels at least a portion of an internal stress imparted to the reticle by at least the multilayer film.

27. An apparatus according to Claim 26, wherein the internal stress is imparted to the reticle by a sum of residual stress in the multilayer film and a mean residual stress in the patterned EUV-absorbing layer.

28. An apparatus according to Claim 23, wherein the reticle substrate is made of LE-glass or LE-ceramic.

29. An apparatus according to Claim 28, wherein the reticle substrate is made of LE-ceramic and the electrically conductive layer is a first flattening layer.

30. An apparatus according to Claim 29, wherein the reticle further comprises a second flattening layer formed on the first major surface between the first major surface and the multilayer film.

31. An EUV-microlithography apparatus, comprising:
an illumination-optical system configured to guide a beam of EUV light to a pattern-defining EUV-reflective reticle;
a projection-optical system situated relative to the reticle and illumination-optical system, and configured to guide the beam of EUV light from the reticle to a sensitive substrate, so as to transfer the pattern from the reticle to the sensitive substrate; and
a reticle stage comprising an electrostatic reticle chuck situated and configured to secure the reticle to the reticle stage, wherein the reticle comprises an electrically conductive reticle substrate having first and second major surfaces and a coefficient of linear expansion of 100x10⁻⁹/K or less, a multilayer film formed on the first major surface and configured for reflecting EUV light incident to a surface of the multilayer film, and an EUV-absorbing layer formed on the surface of the multilayer film and patterned so as to define an exposure pattern.

32. An apparatus according to Claim 31, wherein the reticle further comprises a polished flattening layer on the second major surface of the reticle substrate.

33. An apparatus according to Claim 32, wherein the flattening layer is electrically conductive.

34. An apparatus according to any one of Claims 31 to 33, wherein the electrostatic chuck comprises:
a reticle-mounting surface configured to be grounded electrically; and
contact needles extending from the electrostatic chuck toward the polished surface of the flattening layer and configured so as to make and maintain electrical contact with the polished surface so as to apply an electrical potential to the flattening layer sufficient to attract the reticle electrostatically to the reticle-mounting surface.

35. An apparatus according to Claim 34, further comprising a drop-prevention mechanism attached to the reticle stage and configured for preventing an unintended drop of the reticle from the reticle chuck whenever the reticle is mounted electrostatically to the reticle-mounting surface of the reticle chuck.

36. An apparatus according to Claim 32 or 33, wherein the flattening layer imparts a preselected type and magnitude of stress to the reticle that cancels at least a portion of an internal stress imparted to the reticle by at least the multilayer film.

37. An apparatus according to Claim 36, wherein the internal stress is imparted to the reticle by a sum of residual stress in the multilayer film and a mean residual stress in the patterned EUV-absorbing layer.

38. An apparatus according to any one of Claims 31 to 37, wherein the reticle substrate is made of Super Invar.

39. An apparatus according to Claim 38, wherein the reticle further comprises a polished first flattening layer on the second major surface of the reticle substrate.

40. An apparatus according to Claim 39, wherein the reticle further comprises a second flattening layer formed on the first major surface between the first major surface and the multilayer film.

41. A method for transferring a pattern, defmed on a reticle, to a sensitive substrate, the method comprising:
configuring the reticle as an electrically non-conductive reticle substrate having first and second major surfaces, a multilayer film formed on the first major surface and configured for reflecting EUV light incident to a surface of the multilayer film, an EUV-absorbing layer formed on the surface of the multilayer film and patterned so as to define the pattern, and an electrically conductive layer formed on the second major surface;
placing the reticle on an electrostatic chuck of a reticle stage such that the electrically conductive layer contacts a mounting surface of the chuck, and electrostatically energising the chuck to hold the reticle to the chuck;
guiding a beam of EUV illumination light to the reticle so as to illuminate at least a portion of the pattern with the beam, thereby producing an EUV patterned beam carrying an aerial image of the illuminated portion of the pattern; and
guiding the patterned beam from the reticle to a sensitive substrate using a projection-optical system so as to imprint the image, carried by the patterned beam, on the substrate.

42. A method according to Claim 41, wherein:
the mounting surface of the electrostatic chuck is electrically grounded;
the chuck further comprises needle-shaped contact members that extend toward the conductive layer and apply a prescribed voltage to the conductive layer whenever the is mounted on the chuck; and
the chuck secures the reticle to the reticle stage by bringing the conductive layer into contact with the mounting surface while providing the prescribed voltage via the contact members to the conductive layer.

43. A method according to Claim 41 or 42, wherein the conductive layer imparts a preselected type and magnitude of stress to the reticle that cancels at least a portion of an internal stress imparted to the reticle by at least the multilayer film.

44. A method according to Claim 43, wherein the internal stress is imparted to the reticle by a sum of residual stress in the multilayer film and a mean residual stress in the patterned EUV-absorbing layer.

45. A method according to Claim 50, wherein the reticle substrate is LE-glass or LE-ceramic having a coefficient of linear expansion of 100x10⁻⁹/K or less.

46. A method according to Claim 45, wherein the reticle substrate is LE-ceramic and the electrically conductive layer also serves as a first flattening layer.

47. A method according to Claim 46, wherein the reticle further comprises a second flattening layer formed on the first major surface and situated between the reticle substrate and the multilayer film.

48. A method for transferring a pattern, defined on a reticle, to a sensitive substrate, the method comprising:
configuring the reticle as an electrically conductive reticle substrate having first and second major surfaces and a coefficient of linear expansion of 100x10⁻⁹/K or less, a multilayer film formed on the first major surface and configured for reflecting EUV light incident to a surface of the multilayer film, an EUV-absorbing layer formed on the surface of the multilayer film, an EUV-absorbing layer formed on the surface of the multilayer film and patterned so as to define the pattern, and a first flattening layer formed on the second major surface;
placing the reticle on an electrostatic chuck of a reticle stage such that the first flattening layer contacts a mounting surface of the chuck, and energising the chuck electrostatically to hold the reticle to the chuck;
guiding a beam of EUV illumination light to the reticle so as to illuminate at least a portion of the pattern with the beam, thereby producing an EUV patterned beam carrying an aerial image of the illuminated portion of the pattern; and
guiding the patterned beam from the reticle to a sensitive substrate using a projection-optical system so as to imprint the image, carried by the patterned beam, on the substrate.

49. A method according to Claim 48, wherein:
the reticle substrate is made of Super Invar; and
the reticle further comprises a second flattening layer formed on the first major surface and situated between the first major surface and the multilayer film.

50. A method according to Claim 49, wherein the first and second flattening layers are respective conductive metal layers.

51. A method according to Claim 50, wherein:
the mounting surface of the electrostatic chuck is electrically grounded;
the chuck further comprises needle-shaped contact members that extend toward the first flattening layer and apply a prescribed voltage to the first flattening layer whenever the reticle is mounted on the chuck;
the chuck secures the reticle to the reticle stage by bringing the first flattening layer into contact with the mounting surface while providing the prescribed voltage via the contact members to the first flattening layer.

52. A method according to any one of Claims 48 to 51, wherein the first flattening layer imparts a preselected type and magnitude of stress to the reticle that cancels at least a portion of an internal stress imparted to the reticle by at least the multilayer film.

53. A method according to Claim 52, wherein the internal stress is imparted to the reticle by a sum of residual stress in the multilayer film and a mean residual stress in the patterned EUV-absorbing layer.
